# EUROPEAN PATENT SPECIFICATION

(11) **EP 4 187 450 B1**
(45) Date of publication and mention of the grant of the patent: **31.12.2025**
(21) Application number: 23151929.9
(22) Date of filing: 27.11.2019
(51) Int. Cl.: G06N 10/40, G01R 33/035

(54) **FLUX QUBIT READOUT OF TRANSMON QUBITS**
FLUX-QUBIT-AUSLESUNG VON TRANSMON-QUBITS
LECTURE DE BIT QUANTIQUE DE FLUX DE BITS QUANTIQUES TRANSMON

(43) Date of publication of application: 31.05.2023
(62) Divisional of application: 19824119.2
(73) Proprietor: Google LLC, Mountain View, CA 94043 (US)
(72) Inventor: SANK, Daniel Thomas, Mountain View, CA 94043 (US)
(74) Representative: Thorniley, Peter

(56) References cited:
- US-A1- 2016 191 060
- OPREMCAK A ET AL: "Measurement of a Superconducting Qubit with a Microwave Photon Counter", ARXIV.ORG, CORNELL UNIVERSITY LIBRARY, 201 OLIN LIBRARY CORNELL UNIVERSITY ITHACA, NY 14853, 2 March 2018 (2018-03-02), XP081408896, DOI: 10.1126/SCIENCE.AAT4625
- HOWINGTON CALEB ET AL: "Interfacing Superconducting Qubits With Cryogenic Logic: Readout", IEEE TRANSACTIONS ON APPLIED SUPERCONDUCTIVITY, IEEE SERVICE CENTER, LOS ALAMITOS, CA, US, vol. 29, no. 5, 1 August 2019 (2019-08-01), pages 1 - 5, XP011725288, ISSN: 1051-8223, [retrieved on 20190517], DOI: 10.1109/TASC.2019.2908884
- KONSTANTIN N NESTEROV ET AL: "Counting statistics of microwave photons in circuit QED", ARXIV.ORG, CORNELL UNIVERSITY LIBRARY, 201 OLIN LIBRARY CORNELL UNIVERSITY ITHACA, NY 14853, 14 November 2019 (2019-11-14), XP081532323

## Description

### TECHNICAL FIELD

This present subject matter relates to a readout scheme of transmon qubits.

### BACKGROUND

Large-scale quantum computers have the potential to provide fast solutions to certain classes of difficult problems. Multiple challenges in the design and implementation of quantum architecture to control, program and maintain quantum hardware impede the realization of large-scale quantum computing. Reference is made to Opremcak A, et al, Cornell University Library.: "Measurement of a Superconducting Qubit with a Microwave Photon Counter", which discloses an approach to measurement based on a microwave photon counter demonstrating raw single-shot measurement fidelity of 92%.

### SUMMARY

The invention is set out in independent claim 1. The dependent claims set out particular embodiments.

The details of one or more embodiments of the invention are set forth in the accompanying drawings and the description below. Other features, objects, and advantages of the invention will be apparent from the description and drawings, and from the claims.

### BRIEF DESCRIPTION OF THE DRAWINGS

FIG. 1 is a schematic that illustrates an exemplary embodiment of the dispersive measurement scheme for measuring the computational states of a transmon qubit.
FIG. 2 is a schematic that illustrates an exemplary measurement scheme in which a detector qubit is used as a state detector of a data qubit.
FIG. 3 is a schematic that illustrates an exemplary measurement scheme in which a phase qubit is used as a detector qubit of a transmon qubit.
FIG. 4 is a schematic that illustrates an exemplary measurement scheme in which a flux qubit is used as a detector qubit of a transmon qubit.
FIG. 5 is a flow chart that illustrates a method of reading out a state of a transmon qubit using a flux qubit.
FIG. 6 is a flow chart that illustrates a method of calibrating a flux qubit for reading out a state of a transmon qubit.
FIG. 7a is a schematic that illustrates an exemplary embodiment of a flux bias generator.
FIG. 7b is a schematic that illustrates an exemplary embodiment of a transducer in use with a flux qubit.

### DETAILED DESCRIPTION

Quantum computing entails coherently processing quantum information stored in the quantum bits (qubits) of a quantum computer. Superconducting quantum computing is a promising implementation of solid-state quantum computing technology in which quantum information processing systems are formed, in part, from superconducting materials. To operate quantum information processing systems that employ solid-state quantum computing technology, such as superconducting qubits, the systems are maintained at extremely low temperatures, e.g., in the 10s of mK. The extreme cooling of the systems keeps superconducting materials below their critical temperature and helps avoid unwanted state transitions. To maintain such low temperatures, the quantum information processing systems may be operated within a cryostat, such as a dilution refrigerator.

In some cases, large-scale quantum computers may be implemented using transmon qubits or their variants. The transmon qubit includes a large capacitor shunting one or more Josephson junctions, which improves qubit insensitivity to charge noise and allows the qubit to exhibit a long coherence time. Furthermore, high accuracy single and two-logic gate operations have been demonstrated using transmon qubits. When the transmon qubits are used as data qubits for quantum computation operation, reading out the state of these qubits with high fidelity is an important part of the operation.

However, since the computational states of the transmon qubit cannot be distinguished through a single-shot flux or charge measurement, the states of the transmon qubit are measured based on the difference in energy and not based on a difference in flux or charge. Moreover, the energy difference between the two states of the transmon qubit is only one microwave photon. A microwave photon around 5GHz frequency, has only 0.02 meV of energy, and is too low to detect with conventional means. For this reason, a relatively complicated and indirect dispersive measurement scheme is typically employed: Travelling waves are sent into a resonator coupled to the qubit via a transmission line, and depending on the state of the transmon qubit, different degrees of phase shift or amplitude change are imparted on the travelling waves. This scheme requires special equipment with a relatively large volume within the cryostat and is known to cause non-idealities, which may compromise the fidelity of operations performed by the quantum computer, as will be discussed below.

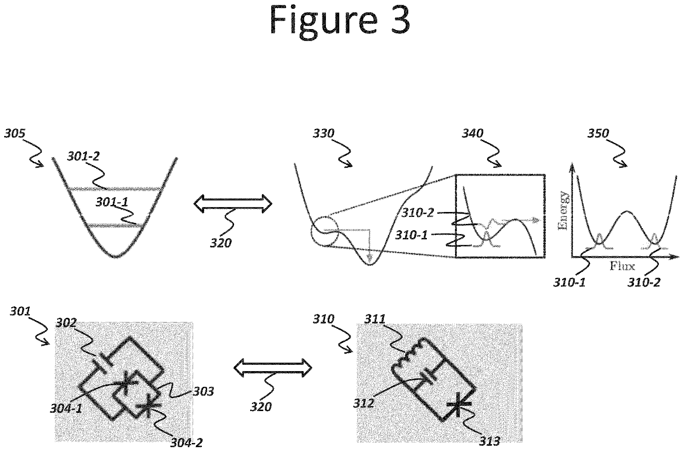

An alternative strategy is to transfer the state of the transmon qubit into another qubit, a detector qubit, where flux or charge measurement is possible. This reduces the need for amplification of the small signal associated with trying to measure a change in the state and the need for sending in a relatively large amount of photons into the transmon qubit. The detector qubit can be dynamically tuned into and out of resonance with the transmon qubit such that the state of the transmon qubit is transferred on demand. This has been tested with a phase qubit as the detector qubit. However, a disadvantage of using a phase qubit as a detector qubit lies in its long dead time which precludes a fast operation, as will also be discussed in FIG. 3 below. Also, when the detection is performed with a phase qubit, the phase qubit state jumps from a shallow potential well to a deep potential well. This leads to emitting many tens of microwave photons, which can propagate to other parts of chip compromising the quantum coherence of the qubits. This will also be discussed in FIG. 3 below.

In order to address these issues, the present disclosure relates to using a flux qubit as a detector qubit and capacitively coupling the flux qubit to the transmon qubit, such that the state of the transmon qubit can be mapped to the flux qubit, and detected by the difference in a self-flux of the flux qubit. The level of self-flux of the flux qubit is large enough to be detected by a technology such as SFQ. Furthermore, the flux qubit does not emit any microwave photons.

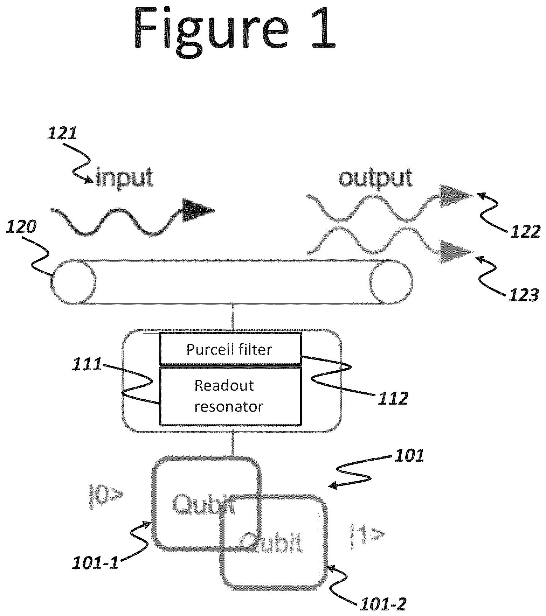

FIG. 1 is a schematic that illustrates an exemplary embodiment of the dispersive measurement scheme for measuring the computational states of a transmon qubit 101.

An input probe signal 121 is sent into a transmission line 120. The input probe signal 121 is a travelling wave which may be one or more guided modes of the transmission line 120. A frequency of the input probe signal 121 may be a microwave frequency at or near a resonance frequency of the transmon qubit 101 such that the transmon qubit 101 may be addressed by the input probe signal 121 either resonantly or dispersively.

The transmon qubit 101 may be coupled to the transmission line 120 via a readout resonator 111. For example, the readout resonator 111 may be a quarter wave co-planar waveguide resonator within a superconducting layer on which the transmon qubit 101 and the transmission line 120 are fabricated. The input probe signal 121 sent into to the readout resonator 111 may acquire a phase shift and/or an amplitude change depending on the state of the transmon qubit 101. The transmon qubit 101 is dispersively coupled to the readout resonator 111. In other words, the resonance frequency of the transmon qubit 101 is detuned from the centre frequency of the readout resonator 111. The transmon qubit 101 and the readout resonator 111 form so-called dressed cavity states in which the resonance frequency of the readout resonator 111 changes depending on the state of the transmon qubit 101. Also the nonlinearity of the Josephson junction, therefore the impedance of the transmon qubit 101, depends on the state of the transmon qubit 101. Therefore, the transmission line 120 outputs a first output probe signal 122 if the transmon qubit 101 was in a first state 101-1 and the transmission line 120 outputs a second output probe signal 123 if the transmon qubit 101 was in a second state 101-2. The state of the transmon qubit 101 may be inferred by whether the output signal is the first output probe signal 122 or the second output probe signal 123.

Coupling to the environment via the readout resonator 111 leads to damping of the transmon qubit 101 or the reduction of radiative lifetime T1, which reduces the coherence of the transmon qubit 101. This also places a limit on the measurement time of the transmon qubit 101 and presents a minimum required operation speed. Therefore, in addition to detuning the resonance of the readout resonator 111 from the resonance frequency of the transmon qubit 101, a leakage rate, or a quality factor of the readout resonator 111 may be optimised such that it allows the necessary measurement speed while keeping the damping of the transmon qubit 101 at an acceptable rate.

To further isolate the transmon qubit 101 from the damping of the external circuit, a Purcell filter 112 may be also placed between the transmission line 120 and the transmon qubit 101, for example, in series with the readout resonator 111, on the output side of the readout resonator 111. The Purcell filter 112 decouples the transmon qubit 101 from the external circuit over a frequency range including the resonance frequency of the transmon qubit 101 to suppress the damping of the transmon qubit 101. The photons near the resonance frequency of the transmon qubit 101 can be prevented from being coupled to the external circuit. The Purcell filter may be implemented with, for example, a symmetric pair of quarter wave stubs connected to the ground.

Although a reasonably high accuracy, such as 98% on a single transmon qubit 101, was demonstrated with the dispersive measurement schemes as described in FIG. 1, scaling such dispersive measurement scheme to a system with a large number of transmon qubits 101 may be complicated by several factors. For example, the dispersive measurement schemes as described in FIG. 1 may require a series of elements to amplify a weak signal, a quantum limited parametric amplifier, a low noise cryogenic amplifier such as a high electron mobility transistor (HEMT). The dispersive measurement schemes may further require a magnetically non-reciprocal element, such as a circulator, to isolate the transmon qubit 101 from the noise generated by these amplifiers. These elements may occupy a lot of the limited space of the milliKelvin stage of the cryostat and the heat generated by each element may add up to go beyond the cooling capacity of the cryostat. Moreover, if the output signals 122, 123 are processed by demodulation electronics performing heterodyne detection and thresholding at room temperature, this may further require the implementation of low latency feedback conditioned on the measurement results.

Therefore, the dispersive measurement schemes as described in FIG. 1 may not be suitable in scaling the operation to a large number of transmon qubits 101. Furthermore, although the signal-to-noise ratio of the dispersive measurements may improve with the intensity of the input probe signal 121, it has been observed that too many photons sent into the readout resonator 111 lead to spurious qubit state transitions, which compromise the fidelity of operations.

As an alternative method, the dispersive measurement scheme as described in FIG. 1 may be somewhat simplified using a Josephson Photo-Multiplier (JPM) as a microwave photon counter at the output of the transmission line 120 to detect the output signals 122, 123. The Josephson Photo-Multiplier includes a single Josephson junction in an rf superconducting quantum interference device (SQUID) loop that is biased close to the critical flux where a phase slip occurs. The transmon qubit 101 may still be dispersively coupled to the readout resonator 111. However, instead of using a circulator and multiple stages of amplifiers, a difference in the photon occupation of the readout resonator 111 may be detected by the Josephson PhotoMultiplier. The detection and discrimination of the states of the transmon qubit 101 may therefore be performed directly at the millikelvin stage of the cryostat by the Josephson photomultiplier. The single-shot measurement fidelity demonstrated to date using this scheme is 92%.

These relatively complex dispersive measurement schemes have been used because a single photon detector in the microwave frequency range is difficult to implement. The states of the transmon qubit 101 have no difference in the first moment of their charge or flux wave functions and only differ in energy by a single microwave photon. There are differences in the higher moments of charge and flux, but those are known to be hard to measure to be feasible as a measurement scheme of the transmon qubit 101.

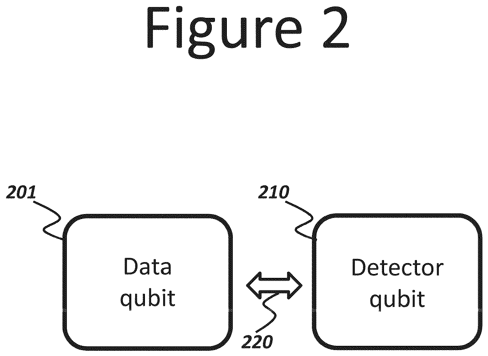

FIG. 2 is a schematic that illustrates an exemplary measurement scheme in which a detector qubit 210 is used as a state detector of a data qubit 201.

The data qubit 201 may be a superconducting qubit that is arranged to take part in the quantum computation with other data qubits 201. The data qubit 201 may therefore be arranged to exhibit a level of nonlinearity required to perform the quantum computation and arranged to receive excitation microwave pulses and flux biases, as required for the quantum computation. For example, the data qubit 210 may be the transmon qubit 101.

The data qubit 201 may be arranged to be coupled to the detector qubit 210 via a coupling element 220.

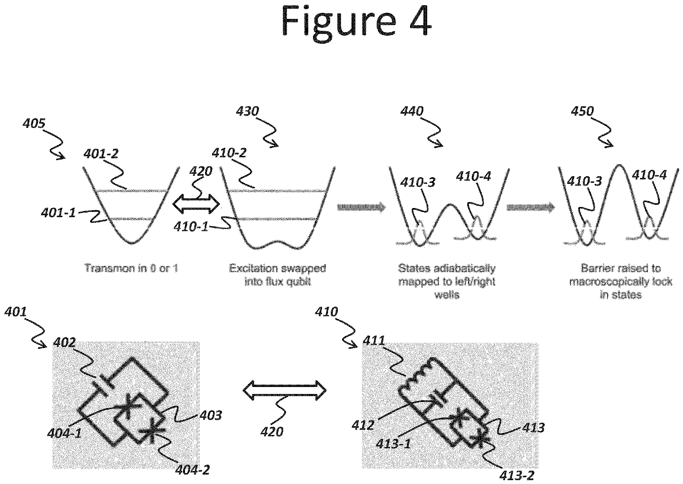

The detector qubit 210 may be any one type of a superconducting qubit, which includes one or more Josephson junctions. For example, the detector qubit 210 may be a phase qubit or a flux qubit. The techniques for reading out a phase qubit or a flux qubit will be described later in FIGS. 3 and 4. Alternatively, the detector qubit 210 may comprise any other type of qubits, such as a microwave transition of a quantum dot, a diamond N-V centre, or a Rydberg atom, which can be resonant with the transition frequency of the data qubit 201. Depending on the type of detector qubit 210, any suitable technique may be used to read out the state of the detector qubit 210. The detector qubit 210 may allow measurement of the energy states of the data qubit 201 based on the quantities such as flux, charge, or UV/visible/near IR photons.

The detector qubit 210 may be capable of being dynamically tuned into and out of resonance with the data qubit 201. When the detector qubit 210 is tuned into or near the resonance of the data qubit 201, the state of the data qubit 201, or the photon of the data qubit 201, may be able to be swapped with the state of the detector qubit 210. In other words, the data qubit 201 and the detector qubit 210 may be coupled such that the interaction between the data qubit 201 and the detector qubit 210 may be in the form of a virtual photon or an exciton, which is a quantum of the excitation shared by the data qubit 201 or the detector qubit 210. This is because the state of data qubit 201, which may be the superposition of the ground state and the first excited state of the data qubit 201, may exhibit quantum coherent oscillation between the data qubit 201 and the detector qubit 210. For the rest of the specification, the word "photon being swapped" between the data qubit 201 and the detector qubit 210 will be understood in this context, namely that the photon may refer to any intermediary quanta of the interaction between the data qubit 201 and the detector qubit 210 and not be limited to an isolated quanta of propagating light. For example, the "photon being swapped" may also refer to the exciton or the virtual photon delocalized between the data qubit 201 and the detector qubit 210. In this sense, the detector qubit 210 may act as a single photon detector of the data qubit 201.

The coupling element 220 may comprise a capacitive coupling in which the data qubit 201 and the detector qubit 210 are coupled to each other capacitively. For example, the metallic parts of the data qubit 201 and the detector qubit 210 may be placed in close proximity to allow capacitive coupling. For another example, a capacitor may be placed in between the data qubit 201 and the detector qubit 210. Alternatively, the coupling element 210 may comprise an inductive coupling in which the data qubit 201 and the detector qubit 210 are coupled to each other inductively. For example, the inductive parts of the data qubit 201, such as loops or elongated parts, of the data qubit 201 and the detector qubit 210 may be positioned such that a magnetic flux generated by the data qubit 201 may generate a current in the detector qubit 210, and vice versa. Alternatively, the coupling element 210 may comprise a combination of the inductive coupling and the capacitive coupling. Alternatively, the coupling element 210 may comprise a transmission line, such as a co-planar waveguide. Alternatively, the coupling element 210 may comprise a superconducting coupler qubit disposed between the data qubit 201 and the detector qubit 210. In this case, the resonance frequencies of the data qubit 201 and the detector qubit 210 need not be tuned to come in and out of resonance with each other and only the superconducting qubit being used as the coupling element 210may be controlled to adjust the coupling between the data qubit 201 and the detector qubit 210. Alternatively, the coupling measure 210 may comprise a Josephson junction parametric amplifier or Josephson junction parametric converter.

In order for the state of the transmon qubit 201 to be transferred to the detector qubit 210, either the resonance frequency of the transmon qubit 201 or the resonance frequency of the detector qubit 210 may be tuned dynamically. In case the coupling measure 210 is another superconducting qubit, the coupling measure 210 may be tuned dynamically. The quantum states occupied in the data qubit 201 and the detector qubit 210 may be time-dependent and may exhibit quantum coherent oscillations. The time-dependence of the states may be determined by the degree of interaction between the data qubit 201 and the detector qubit 210. By dynamically tuning in and out of mutual resonance, the state of the transmon qubit 201 may be mapped or transferred to the detector qubit 210. The swapping of the photon may be performed either partially or wholly, depending on the duration of the interaction. The swapping of the state between the data qubit 201 and the detector qubit 210 may be performed within the coherence time of the data qubit 201 and the detector qubit 210.

The concept of using another qubit as the detector qubit 210 has been tested with a phase qubit 310 as the detector qubit 210.

FIG. 3 is a schematic that illustrates an exemplary measurement scheme in which the phase qubit 310 is used as the detector qubit 210 to detect the state of a transmon qubit 301 as the data qubit 201, with references to FIG. 2.

The transmon qubit 301, used as the data qubit 201 in this example, may comprise a capacitor 302 and a SQUID loop 303 which contains a first Josephson junction 304-1 and a second Josephson junction 304-2. FIG. 3 shows a schematic drawing of a potential curve 305 of the transmon qubit 301, which specifies a ground state 301-1 and a first excited state 301-2 of the transmon qubit 301. Due to the anharmonicity of the potential curve 305 or the nonlinearity of the transmon qubit 301, the energy levels of the states are not equally spaced, and a microwave excitation resonant with the transition from the ground state 301-1 to the first excited state 301-2 may be largely off-resonant to the other transitions. Therefore, although there exists higher excited states, these two states 310-1, 310-2 may be considered as a computational space of the transmon qubit 301. The larger the nonlinearity of the transmon qubit 301 is, the larger the difference is between the frequency of the transition from the ground state 301-1 to the first excited state 301-2 and the frequency of the transition from the first excited state 301-2 to a second excited state, which is not shown in the potential curve 305.

The phase qubit 310, used as the detector qubit 210 in this example, may comprise a Josephson junction 313, a capacitor 312, and an inductor 311. The inductor 311 may be inductively coupled to a line carrying a flux bias current. A potential curve 330, 340, 350 of the phase qubit 310 as a function of flux may comprise a double well structure. The wave functions may be narrowly confined in each well, as shown in the rightmost potential curve 350. Since the bottom of each potential well can be approximated as a quadratic function, therefore a harmonic potential well, the energy spacing between the states near the bottom of the potential well may be largely equally spaced. Therefore, the anharmonic nature of the potential well is not pronounced and the phase qubit 310 may exhibit a substantially linear behavior. To recover the nonlinearity, a bias current or a flux bias may be applied to introduce asymmetry in the potential curve as shown in the leftmost potential curve 330 of the phase qubit 310.

The leftmost potential curve 330 shows that a left potential well, circled and shown in detail in a potential curve 340, is made shallow such that only a ground state 310-1 and a first excited state 310-2 can be confined within the left potential well. The computational space of the phase qubit 310 may be provided by the ground state 310-1 and the first excited state 310-2 in the left potential well under this flux bias condition.

For the measurement of the state of the phase qubit 310, a short bias pulse may be provided to momentarily lower the height of the barrier between the left well and the right well. As indicated by an arrow in the potential curve 340, this may allow the first excited state 310-2 to tunnel out of the shallow left well and fall into the deep right well but mainly prevent the ground state 310-1 from exiting the left well. Consequently, the barrier between the left well and the right well may be heightened again and the potential curve 350 may be brought back into a symmetric shape. Then the ground state 310-1 and the first excited state 310-2 may be separated and trapped in the left well and the right well, respectively. In other words, the barrier between the left well and the right well may largely suppress tunneling between the two wells. Then the two flux states, corresponding to the wave functions narrowly confined in the left well and the right well, respectively, may be detected and distinguished by magnetic flux. The amount of the flux generated by the phase qubit 310 on each flux state will be referred to as "self-flux" in this specification. The self-flux of the phase qubit can be measured using devices such as a SQUID or a SFQ (Single Flux Quantum) circuitry.

The transmon qubit 310 may be coupled to the phase qubit 330 by a coupling element 320. As discussed in FIG. 2, the coupling element 320 may be any one of capacitive coupling, inductive coupling or combination of the capacitive coupling and the inductive coupling, a transmission line, a coupler superconducting qubit, a Josephson parametric converter or Josephson parametric amplifier. The transmon qubit 301, as a result of the quantum computation in cooperation with other transmon qubits 301, may carry a quantum state, which is a superposition state between the ground state 301-1 and the first excited state 301-2. In order to detect the quantum state currently existing in the transmon qubit 301, the phase qubit 310 may be tuned into resonance with the transmon qubit 301. Alternatively, in order to detect the quantum state currently existing in the transmon qubit 301, the transmon qubit 301 may be tuned into resonance with the phase qubit 310. By being dynamically tuned in and out of resonance with the transmon qubit 301, the photon of the transmon qubit 301 may be swapped into the phase qubit 310. In other words, the phase qubit 310 may receive the quantum state onto the computational space of the phase qubit 330, which is the shallow left well as shown in the potential curve 340. In still other words, the superposition state of the ground state 301-1 and the first excited state 301-2 of the transmon qubit 301 may be mapped onto a superposition state of the ground state 310-1 and the first excited state 310-2 of the phase qubit 310. As discussed above, by applying a flux bias pulse to lower the barrier between the left well and the right well, the ground state 310-1 and the first excited state 310-2 of the phase qubit 310 may be separated into two different flux states, as shown in the rightmost potential curve 350. The flux may be measured using devices such as a SQUID or a SFQ circuitry. Therefore, the phase qubit 310 may be used as a single photon detector or the state detector of the transmon qubit 301. The quantum state was distinguished with 90% accuracy with a very short pulse, roughly 10ns, to lower the barrier.

However, there are several disadvantages in using the phase qubit 310 as the detector qubit 210. Once a single photon is swapped into the phase qubit 310, in order to separate the two flux states 310-1, 310-2, the phase qubit 310 is biased so that the first excited state 310-2 has a higher probability than the ground state 310-1 of tunnelling out of the metastable, shallow left well. However, the tunnelling rate difference between the ground state 310-1 and the first excited states 310-2 is large enough only to provide ~96% maximum theoretical contrast. Furthermore, the decay of the tunnelled first excited state 310-1 to the bottom of the right well of the potential curve 330, 340, 350 is a dissipative process. Emission of energy during this process has been observed to drive neighbouring qubits into excited states, causing measurement crosstalk errors. The process of tunnelling into the right hand well also renders the phase qubit 310 lose the phase coherence due to the dissipative evolution of the wave function. Therefore, to be used again as the detector qubit 210, the phase qubit 310 need to be reset such that the ground state 310-1 and the first excited state 310-2 are reset in the left shallow well of the potential curve 330, 340, 350. Practical reset times for the phase qubit 310 are known to be in the tens to hundreds of microseconds, which may be long compared to the coherence times of currently available transmon qubits 301.

To address the issues of the dispersive detection scheme described in FIG. 1 and the issues in using the phase qubit 310 as the detector qubit 210 described in FIG.3, the present specification discloses using a flux qubit 410 as the detector qubit 210, such that the state of the transmon qubit 401 can be mapped to the flux qubit 410 coupled to the transmon qubit, and detected by the difference in the self-flux of the flux qubit 410.

FIG. 4 is a schematic that illustrates an exemplary measurement scheme in which the flux qubit 310 is used as the detector qubit 210 to detect the state of a transmon qubit 301 as the data qubit 201, with references to FIGS. 2 and 3.

The transmon qubit 401, used as the data qubit 201 in this example, may comprise a capacitor 402 and a SQUID loop 403 which contains a first Josephson junction 404-1 and a second Josephson junction 404-2. FIG. 4 shows a schematic of a potential curve 405 of the transmon qubit 401, which specifies a ground state 401-1 and a first excited state 401-2 of the transmon qubit 401. Although there exists higher excited states, only these two states may be considered as a computational space of the transmon qubit 401 for the reasons discussed above in FIG. 3.

The flux qubit 410, used as the detector qubit 210 in this example, may comprise a SQUID loop 413 including a first Josephson junction 413-1 and a second Josephson junction 413-2 and an inductor 411. Importantly, the flux qubit 410 is shunted with a capacitor 412. The capacitance of the capacitor 412 may be set to be large enough such that it may behave like a transmon qubit under a certain range of flux bias. Although a larger capacitance of the capacitor 412 may increase the phase coherence of the flux qubit 410, it may reduce the nonlinearity. A higher coherence prolongs the time window of interaction between the transmon qubit 401 and the flux qubit 410. Since the flux qubit 410 is used as the detector qubit 210, the capacitance may be set to lengthen the coherence time rather than keeping the nonlinearity in the range to be used as the data qubit 201. In this case, the capacitance of the capacitor 412 may range from 10fF to 100fF. Alternatively, the capacitance of the capacitor 412 may be determined such that the flux qubit 410 may be used interchangeably between the data qubit 201 and the detector qubit 210. In this case, the capacitance of the capacitor 412 may range from 1fF to 50fF.

The inductance of the inductor 411 may be determined to be as large as possible to minimize the effects of magnetic flux noise. However, there are practical constraints including the fact that a coil-wound inductor has self-resonances when the size of the inductor 411 is too large. Typically, this can be overcome by using additional Josephson junctions 413-1, 413-2 to increase inductance without adding coil length.

A potential energy curve 430, 440, 450 of the flux qubit 410 as a function of flux may comprise a double well structure, which includes two wells separated by a potential barrier, in which each of the wells corresponds to a different discrete flux states, a left flux state 410-3 and a right flux state 410-4. When the barrier between the two wells is high enough, the wave functions are narrowly confined in each well, as shown in the rightmost potential curve 450. In other words, the barrier between the left well and the right well may be high enough to largely suppress tunneling of the left flux state 410-3 and the right flux state 410-4 between the two wells. For example, for a flux qubit 410 where the self-resonance of the inductor 411 and the capacitor 412 is around 20GHz, a barrier of 2meV may suppress the tunneling rate to 1Hz.

The two flux states 410-3, 410-4 may be detected and distinguished by the magnetic flux generated by the flux qubit 410 depending on the flux state. As in the phase qubit 310, the amount of the flux generated by the flux qubit 410 on each flux state 410-3, 410-4 will be referred to also as "self-flux" in this specification. The difference in the self-flux between the left flux state 410-3 and the right flux state 410-4 may be as large as a single flux quantum. The self-flux of the flux qubit 410 can be measured using devices such as a SQUID or a SFQ circuitry or other equivalent devices capable of measuring the self-flux. The difference in the self-flux between the left flux state 410-3 and the right flux state 410-4 may slightly deviate from a single flux quantum or Φ₀. This is because the parabolic potential of the inductor 411 may cause the double well to deviate from the ideal periodicity of the junction potential, which corresponds to a single flux quantum. In case superinductance is used for the inductor 411 or the SQUID 413 for the Josephson junctions 413-1, 413-2, these nonidealities may render the difference in the self-flux further deviate from the single flux quantum.

The shape of the potential energy curve can be controlled with a first flux bias threading through the whole circuit of the flux qubit 410 and a second flux bias threading through the SQUID loop 413 of the flux qubit 410. By controlling these two flux biases separately and dynamically, mapping the state of the transmon qubit 401 to the flux qubit 410 and the subsequent measurement of the flux state of the flux qubit can be performed, as explained in more detail later.

By applying the first flux bias threading through the whole circuit of the flux qubit 410, or mostly through the inductor 411 of the flux qubit 410, the potential energy curve 440, 450 of the flux qubit 410 can be "tilted," in other words, an asymmetry in energy is introduced between the two discrete flux states 410-3, 410-4. In the example shown in the potential energy curves 440, 450, the energy of the left flux state 410-3 is lower than the energy of the right flux state 410-4.

Tilting of the potential energy curve 440, 450 localizes the hybridized energy states 410-1, 410-2 of the flux qubit 410 into the two flux states 410-3, 410-4 of the flux qubit 410 corresponding to the states confined within the two wells. When the potential curve is not tilted, the two flux states of the flux qubit 410 both occupy a ground state of each well with a substantially identical energy. When the barrier height is finite, these two flux states 410-3, 410-4 form two hybridized states 410-1, 410-2 delocalized over the two wells, as shown in the potential curve 430. The potential curve 430 corresponds to a case where the barrier between the two wells is minimized. Even if there is a finite barrier between the two wells, the hybridized states 410-1, 410-2 will be also delocalized over the two wells via tunneling through the barrier. These two hybridized states form two different energy levels, a ground state 410-1 and a first excited state 410-2 as indicated in the potential curve 430.

Without tilting, each of the energy state 410-1, 410-2 will map into either the left flux state 410-3 or the right flux state 410-4 with an equal probability when the barrier is heightened. Therefore, the energy states 410-1, 410-2 may not be distinguished based on the self-flux.

By applying the second flux bias threading through the SQUID loop 413 of the flux qubit 410, the critical current of the Josephson junctions 413-1, 413-2 can be controlled. This consequently changes the height of the potential barrier between the two flux states 410-3, 410-4 and also changes the resonance frequency of the flux qubit 410.

Due to tilting the potential energy curve 430, 440, 450 such that the left well has a lower energy than the right well, as the barrier height is adiabatically heightened, the ground state 410-1 will be guided into the left flux state 410-3 and the first excited state 410-2 will be guided into the right flux state 410-4.

In particular, the area of the SQUID loop 413 of the flux qubit 410 may be arranged to be large enough such that the second flux bias, through the SQUID loop 413, may be applied largely independent of the first flux bias. The area may be, for example, 1 µm² to 100 µm². In some implementations, the area of the SQUID loop 413 may be around 40 µm². Although such a large area of the SQUID loop 413 may render the flux qubit 410 more sensitive to the flux noise or the stray capacitance, the capability of controlling the barrier height and the resonance frequency largely independent of the tilt of the potential may be important in using the flux qubit 410 as the detector qubit 210, as will be explained below.

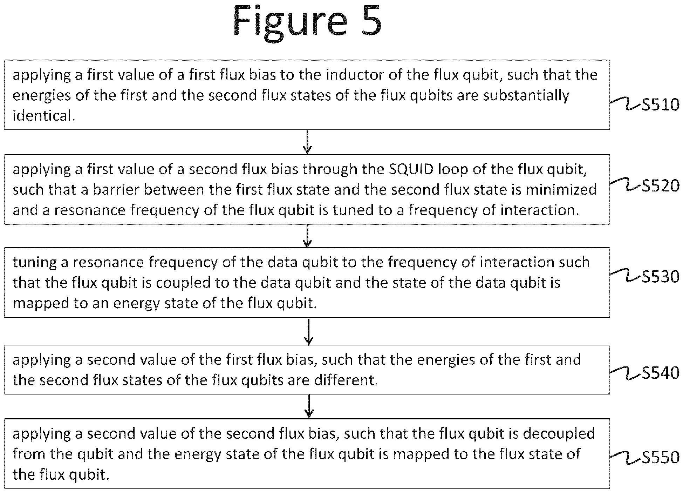

FIG. 5 shows a flow chart that illustrates a method of reading out a state of the transmon qubit 401 using the flux qubit 410 with references to FIGS. 1, 2 and 4.

In step 510, a first value of the first flux bias may be applied to the flux qubit 410 such that the potential energy curve 430, 440, 450 of the flux qubit 410 is largely symmetrical. At this state, the resonance frequency of the transmon qubit 401 may be far detuned from the resonance frequency of the flux qubit 410 such that the interaction between the transmon qubit 410 and the flux qubit 410 is not significant. For example, the resonance frequency of the transmon qubit 410 may be detuned from the resonance frequency of the flux qubit 410 by 2GHz or more.

In some cases, a second value of the second flux bias may be applied for this detuning condition, as will be explained in more detail in step 550.

In step 510, the transmon qubit 401 may be excited such that the state of the transmon qubit 401 is prepared.

In step 520, a first value of the second flux bias may be applied to the flux qubit 410. At the first value of the second flux bias, the barrier height is minimized as shown in the potential energy curve 430 and the flux qubit 410 is brought into an interaction frequency at which it will interact with the transmon qubit 401 and the state of the transmon qubit 410 will be mapped to the flux qubit 410. At the first value of the second flux bias, the flux qubit 410 may be arranged to receive the photon from the transmon qubit 401 such that the quantum state can oscillate between the transmon qubit 401 and the flux qubit 410. As discussed above, the second flux bias, applied through the SQUID loop 413, controls the barrier height between the two wells and the resonance frequency of the flux qubit 410. The phase coherence of the flux qubit 410 is maximized under this condition, which provides a time window for coherent interaction with the transmon qubit 410. The T1 time of the flux qubit 410 may be around 30µs. In step 520, the first value of the first flux bias applied in step 510 may be maintained such that the potential energy curve 430, 440, 450 of the flux qubit 410 remains symmetrical.

In step 530, the transmon qubit 401 may be tuned into resonance with the flux qubit 410, to the interaction frequency, such that if the transmon qubit 401 is excited, the photon is swapped into the flux qubit 410. A superposition state of the ground state 401-1 and the first excited state 401-2 may be mapped into a superposition state of the ground state 410-1 and the first excited state 410-2 of the hybridized energy states of the flux qubit 410.

In some implementations, steps 520 and 530 may be performed simultaneously.

In some implementations, if the transmon qubit 401 and the flux qubit 410 are tuned into resonance in step 520 by application of the first value of the second flux, step 530 may be omitted.

In case the transmon qubit 401 is excited in step 510 to have a state prepared within the transmon qubit 401, steps 520 and 530 may be performed immediately following the excitation of the transmon qubit 401.

In step 540, a second value of the first flux bias may be applied to the flux qubit 410 such that the potential energy curves 430, 440, 450 are tilted. Then the energies of the first flux state 410-3 and the second flux state 410-4 may become different. As explained in FIG. 4, this is such that the energy states 410-1, 410-2 can be mapped into the left flux state 410-3 and the right flux state 410-4 as the barrier is adiabatically heightened in step 550.

The first value of the second flux bias applied in step 520 may be maintained such that the height of the barrier remains minimized at this stage. In some implementations, steps 530 and 540 may be performed simultaneously. In some implementations, the second value of the first flux bias may be applied to the flux qubit 410 throughout the procedure such that the potential energy curve 430, 440, 450 of the flux qubit 410 is always tilted. This is on the condition that swapping of the state in steps 520 and 530 is not affected by the tilt of the potential energy curve 430, 440, 450 of the flux qubit 410.

In step 550, the second value of the second flux bias may be applied to the flux qubit 410 such that the barrier between the two wells are heightened to "lock in" the flux states 410-3, 410-4 such that the tunneling between the left flux state 410-3 and the right flux state 410-4 may be substantially suppressed. As discussed above, in some implementations, the height of the barrier may be around 2meV. The transition from the first value to the second value of the second flux bias is adiabatic, in other words, gradual to minimize the probability of the flux qubit changing state. The flux states 410-3, 410-4 can be preserved in the wells for sufficient amount of time before measurements. By having a large barrier. the qubits will stay in their respective wells much longer without tunneling, removing the need to immediately measure like in some of the current systems.

The second value of the second flux bias may also bring the flux qubit 410 out of resonance with the transmon qubit 401 by tuning away from the interaction frequency. The measurements of the state of the flux qubit 410 may be made when the flux qubit 410 is far detuned from the transmon qubit 401. The detuning may be, for example, by 2GHz or more.

When the microwave reflectometry is employed for state detection, the second value of the first flux bias applied in step 530 may be maintained to keep the potential energy curves 430, 440, 450 asymmetric, as will be discussed in more detail later.

The resonance frequency of the transmon qubit 401 may also be tuned away from the interaction frequency such that the interaction between the transmon qubit 401 and the flux qubit 410 is not significant.

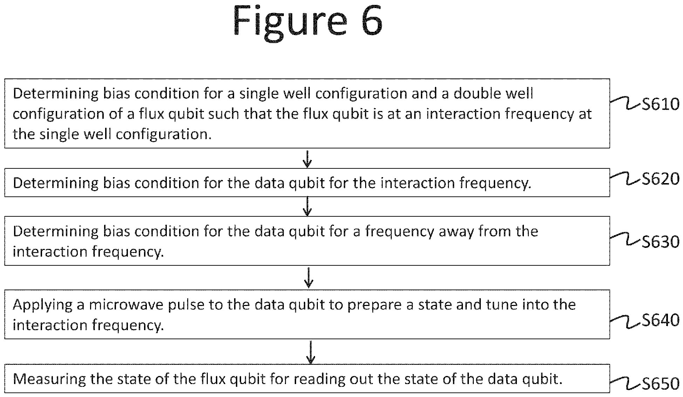

A time interval between steps 520, 530 for bringing the transmon qubit 401 and the flux qubit 410 into resonance and steps 540, 550 for measuring the state from the flux qubit 410 may be determined in view of the quantum coherent oscillations between the transmon qubit 401 and the flux qubit 410 such that the flux qubit 410 is decoupled from the transmon qubit 401 at the moment when the mapping of the state of the transmon qubit 401 is complete. For example, in order to determine the time interval for maximum transfer efficiency between the transmon qubit 401 and the flux qubit 410, the transmon qubit 401 may be excited to have a predetermined quantum state at step 510. After the transmon qubit 401 and the flux qubit 410 are brought into resonance by performing steps 520 and 530, a first time interval T may be introduced before steps 540 and 550 may be performed to measure the state transferred to the flux qubit 410. These steps 510, 520, 530, 540, 550 can be repeated while varying the first time interval T. The duration of the first time interval T for maximizing the transfer efficiency between the transmon qubit 401 and the flux qubit 410 can be determined, which gives maximum detection probability at the flux qubit 410. FIG. 6 shows a flow chart that illustrates a method of calibrating the flux qubit 410 for reading out a quantum state of the transmon qubit 401, with references to FIGS. 4 and 5.

At step 610, the first value of the second flux bias, a condition for a single well configuration, and the second value of the second flux bias, a condition for a double well configuration for locking up the flux states 410-3, 410-4, of the flux qubit 410 may be determined. The first value of the second flux bias may be determined such that the resonance frequency of the flux qubit is at the interaction frequency.

At step 620, the bias condition of the transmon qubit 401 to bring the resonance frequency of the transmon qubit 410 to the interaction frequency may be determined.

At step 630, the resonance frequency of the transmon qubit 401 may be tuned away from the interaction frequency and the resonance frequency away from the interaction frequency may be probed spectroscopically by sending in microwave pulses while sweeping the frequency of the pulses. The first value of the second flux bias is applied to the flux qubit 410 to lower the potential barrier such that once the transmon qubit 401 is brought into the interaction frequency, the photon can be swapped from the transmon qubit 401 into the flux qubit 410.

The rest of the procedure relates to determining the time interval for maximum transfer efficiency between the transmon qubit 401 and the flux qubit 410, which was discussed above.

At step 640, microwave pulses may be sent into the transmon qubit 401 to prepare a quantum state within the transmon qubit 401. This step may be performed at step 510 described above.

Shortly after sending in each pulse to prepare a quantum state in the transmon qubit 401, in other words within a time scale much shorter than the coherence time of the transmon qubit 401, the resonance frequency of the transmon qubit 401 may be tuned into the interaction frequency. This may be achieved by following steps 520 and 530 described above.

After the transmon qubit 401 and the flux qubit 410 are brought in to resonance, a first time interval T may be introduced.

During the first time interval T, the prepared quantum state of the transmon qubit 401 may be transferred, to the flux qubit 410.

At step 650, the state of the transmon qubit 401 may be read out by measuring the state of the flux qubit 610 by following steps 540 and 550 described above.

By repeating steps 640 and 650 while varying the first time interval T, the duration of the first time interval T for maximizing the transfer efficiency between the transmon qubit 401 and the flux qubit 410 can be determined. Therefore, the readout condition of the transmon qubit 401 may be established.

The step 640 and 650 may be performed within the coherence time of the transmon qubit 401 from the moment of the microwave pulse to prepare the quantum state. In other words, the first time interval T may be varied within the coherence time of the transmon qubit 401.

In relation to measuring the state of the flux qubit 410, there may be at least two ways, as explained below.

A microwave reflectometry may be used to discern the left flux state 410-3 and the right flux state 410-4. The flux qubit 410 may be biased such that the left well and the right well behave like classical harmonic oscillators with different spacing of levels. For example, this may be achieved by adjusting the second flux bias such that each well becomes deep and the bottom of each well can be approximated as a harmonic potential and adjusting the first flux bias such that the asymmetry between the two wells are large enough to be detected by the difference in the spacings between the ground state and the first excited state of each well. Such frequency difference may be detected with microwave reflectometry, analogous to the dispersive scheme described in FIG. 1. However, since a relatively large intensity of input probe signal 121 may be used to detect the frequency difference, amplifiers and circulators may not be necessary to detect ouput signals 122, 123 may be necessary.

Alternatively, the self-flux of the flux qubit 410 may be directly measured. The magnetic flux of the left flux state 410-3 and the right flux state 410-4 may differ by a magnetic flux quantum, which may be detectable by SFQ (single flux quantum) circuitry or SQUID magnetometer. For example a QFP (quantum flux parametron) may be coupled to the flux qubit 410 and the SFQ pulse trains may be sent to the QFT to readout the QFP state, which provides the state readout of the flux qubit 410.

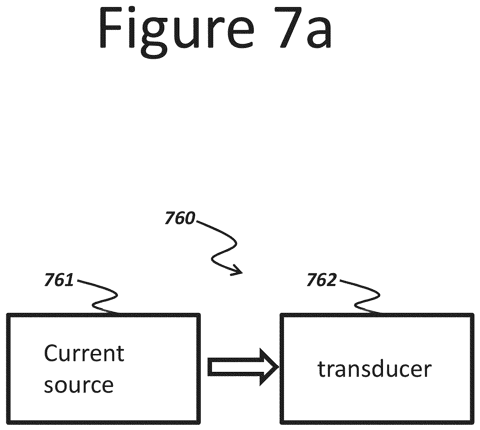

FIG. 7a is a schematic that illustrates an exemplary embodiment of a flux bias generator 760.
The flux bias generator 760 comprises a current source 761 configured to generate a current and a transducer 762 arranged to convert the current into a magnetic field. The transducer 762 may be arranged to generate the first flux bias and the second flux bias within the range necessary to perform the methods described above in FIGS. 5 and 6.

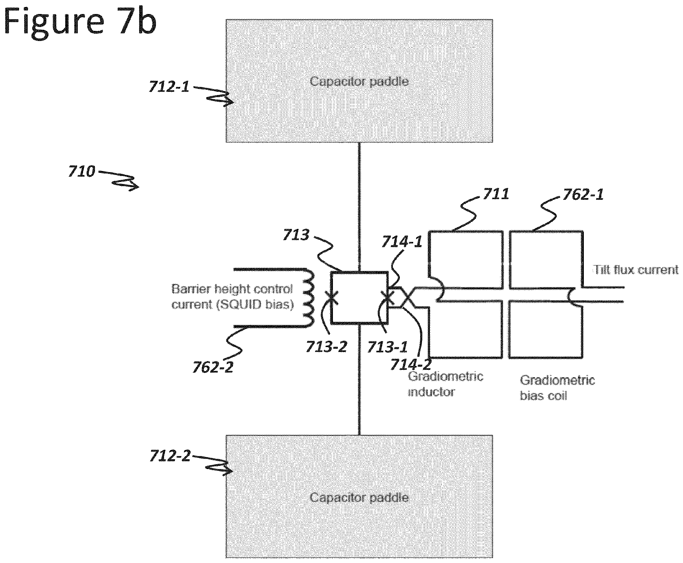

FIG. 7b is a schematic that illustrates an exemplary embodiment of the transducer 762 in use with the flux qubit 710 with references to FIG. 4.

As discussed in FIG. 4 above, the flux qubit 710 comprises an inductor 711, a capacitor 712 and a SQUID loop 713 including a first Josephson junction 713-1 and a second Josephson junction 713-2. As discussed above, since the flux qubit 710 includes a large shunt capacitance, in some implementations, the capacitor 712 is in the form of a paddle, which comprises a first capacitor pad 712-1 and a second capacitor pad 712-2 on each side of the SQUID loop 713. When the capacitor 712, 712-1, 712-2 is in the form of a paddle, the capacitor may be increased by increasing the area of the paddle. The first capacitor pad 712-1 and the second capacitor pad 712-2 are respectively electrically connected to two terminals formed between the first Josephson junction 713-1 and the second Josephson junction 713-2 along the SQUID loop 713. The first capacitor pad 712-1 and the second capacitor pad 712-2 are connected to the inductor 711 via a first wire 714-1 and a second wire 714-2, respectively. A first end of the first wire 714-1 and the second wire 714-2 may stem from the SQUID loop on each side of the first Josephson junction 713-1, the first wire 714-1 directly connected to the first capacitor pad 712-1 and the second wire 714 directly connected to the second capacitor pad 712-2, respectively, via the SQUID loop 713. A second end of the first wire 714-1 and the second wire 714-2 are electrically connected to the two terminals of the inductor 711.

In some implementations, the inductor 711 may comprise a gradiometric coil. As shown in FIG. 2, starting from the two terminals connected to the first wire 714-1 and the second wire 714-2, the inductor 711 forms two loops next to each other such that when a current is flown into the inductor 711, the magnetic fields generated at the two loops are in opposite directions to each other. Therefore, when a magnetic field is applied threading through the overall area of the inductor 711, for example, for the second flux bias, the effect of the magnetic field through the two loops formed within the inductor 711 largely cancel each other. When magnetic fields of opposite directions are coupled into the two loops formed within the inductor 711, the generation of inductive current may be efficient.

The transducer 762 includes a first coil 762-1 and a second coil 762-2. As discussed above in FIG. 4, the shape of the potential energy curve can be controlled with a first flux bias threading through the whole circuit of the flux qubit 410, 710, or mostly through the inductor 411, 711 of the flux qubit 410, 710 and a second flux bias threading through the SQUID loop 413, 713 of the flux qubit 410, 710. By controlling these two flux biases separately and dynamically, mapping the state of the transmon qubit 401 to the flux qubit 410, 710 and the subsequent measurement of the flux state of the flux qubit can be performed.

The first coil 762-1 is used for applying the first flux bias threading through the inductor 711 of the flux qubit 710, such that the potential energy curve 440, 450 of the flux qubit 410, 710 can be "tilted," in other words, an asymmetry in energy is introduced between the two discrete flux states 410-3, 410-4.

When the inductor 711 of the flux qubit 710 is configured as a gradiometric coil as discussed above, the first coil 762-1 may be also configured as a gradiometric coil such that the magnetic flux from the first coil 762-1 is only efficiently coupled to the inductor 711 and less efficiently to the other parts of the flux qubit 710, such as the SQUID loop 713.

In some implementations, the first wire 714-1 and the second wire 714-2 may be arranged to cross, in other words, to be on top of each other at at least one position without being electrically connected to each other, such that parasitic coupling of the second flux bias from the second coil 762-2 into the inductor 711 is reduced. For example, FIG. 7b shows that the first wire 714-1 and the second wire 714-2 are arranged cross once between the SQUID loop 713 and the inductor 711. However, the number of crossing between the first wire 714-1 and the second wire 714-2 is not limited to once.

The second coil 762-2 is used for applying the second flux bias threading through the SQUID loop 413, 713 of the flux qubit 410, 710, by controlling the critical current of the Josephson junction 713-1, 713-2. This consequently changes the height of the potential barrier between the two flux states 410-3, 410-4 and also changes the resonance frequency of the flux qubit 410, 710.

When the first flux bias is applied via the inductor in the form of a gradiometric coil, the second flux bias generated from the second coil 762-2 may not be coupled efficiently to the inductor 711 of the flux qubit 710. Therefore, a high degree of independent control of the first flux bias and the second flux bias may be achieved.

Therefore, the magnetic fluxes through the whole circuit of the flux qubit 710 and the SQUID loop 713 may be controlled independently using the first coil 762-1 and the second coil 762-2.

The example given in FIG. 7b is only one embodiment of the transducer 762. Other designs of the transducer 762 may be used to generate the first flux bias and the second flux bias. In some implementations, the transducer 762 may be disposed on a substrate separate from the substrate containing the flux qubit 710. For example, the transducer 762 may be disposed on a face of a substrate which can be approached to a face of the substrate containing the flux qubit 710. The arrangement of the first coil 762-1 and the second coil 762-2 may be such that when the two substrates are laterally aligned, the first coil 762-1 and the second coil 762-2 can be brought to a close proximity to the inductor 711 and the SQUID loop 713, respectively, such that the first flux bias and the second flux bias can be provided.

The flux qubit 410, 710 shunted with a relatively large capacitor may be used as a single photon detector of the transmon qubit 201. The flux qubit 410, 710 may be used as a single photon detector of any other qubit if it can brought into the resonance with a potential energy curve defining energy levels comparable to that of the flux qubit 410 when the barrier height is minimized.

Since the flux qubit 410, 710 allows a negligible error rate in detecting the two flux states 410-3, 410-4, measurement accuracy may be improved, which will provide a high fidelity of operation. The reset time or cycle time of the flux qubit 410, 710 may be determined by the speed at which the barrier height is heightened in step 550. The speed should be low enough to ensure adiabaticity of the process but high enough to allow a reasonable detection and operation speed.

The total footprint of the flux qubit 410, 710 within a chip may be compatible with a two-dimensional grid of the transmon qubits 301, 401. The flux qubit 410, 710 removes the need for parametric amplifier HEMT circulator and alleviates corresponding heat dissipation on chip. It may not suffer from the spurious transitions due to high photon number of the dispersive scheme described in FIG. 1.

To implement a practical large-scale quantum computation involving a large number of qubits, the error rate of the qubits constituting the quantum computer should be below an acceptable threshold. A common scheme adopted for error correction is so-called a "surface code" quantum computer, which includes a two-dimensional array of data qubits and ancillary qubits, or measurement qubits, where nearest neighbors can be coupled to each other. The data qubits and ancillary qubits may form an interleaved grid of two sub-grids.

In the surface code, data qubits and ancillary qubits are entangled together using a sequence of physical qubit CNOT operations, with subsequent measurements of the entangled states providing a means for error correction and error detection. The ancillary qubits are not directly involved in the computation but are couplable to the data qubit for monitoring the state of the data qubit to detect, e.g., an error in the data qubit. In the surface code, a set of data qubits and ancillary qubits entangled in this way is used to define a logical qubit.

Also, a specific sequence of entangling operations, so-called a stabilizer, on pairs of a data qubit and an ancillary qubit may act as stabilizing the state of the data qubit in that it suppresses spurious flipping of the qubit state by a set of measurements. By repeatedly measuring the qubits within a logical qubit using a complete set of commuting stabilizers, the logical qubit collapses into a simultaneous and unique eigenstate of all the stabilizers. One can measure the stabilizers without perturbing the system of the logical qubit. A spurious flipping of the data qubit may be detected when the measurement outcomes change, this corresponds to one or more qubit errors, and the quantum state is projected by the measurements onto a different stabilizer eigenstate.

The number of physical qubits needed to define a logical qubit depends strongly on the error rate of the physical qubits and the arrangement of the ancillary qubits and the data qubits.

In some implementations, the transmon qubits 401, 701 may be used as both data qubits and ancillary or measurement qubits in the surface code quantum computer. The flux qubit 410, 710 described in this specification may be used to read out the state of the ancillary qubits after parity measurements done between the data qubits and the ancillary qubits.

In some implementations, the flux qubit 410, 710 described herein may be used as ancillary qubits, or measurement qubits in the surface code quantum computer. While the ancillary qubits are measuring the parities of the data qubits, the ancillary qubits may be biased into "transmon mode" where the barrier height is minimized, for high coherence. After the parity measurement is done, the flux qubit can be biased into the "double well mode" so that their state can be easily read out using superconducting electronics. This implementation may be advantageous in that the scheme does not require any amplifiers or other microwave circuits to read out the ancillary qubits.

The two-dimensional array of the data qubits, the transmon qubits 301, 401, and the ancillary qubits, the flux qubits, 410, 710, may be implemented on the surface of a single substrate. Alternatively, the flux qubits and the transmon qubits may be disposed on two separate substrates 780, 790, and the faces of the two substrates can be brought into proximity such that the flux qubits can couple to the transmon qubits via, e.g., vacuum capacitance.

In some implementations, both the data qubits and the ancillary qubits can be flux qubits 410, 710 described in this specification. During the coherent operations, all of the flux qubits 410, 710 can be biased in to "transmon mode" where the barrier height is minimized. Then for state measurement of the ancillary qubits, the ancillary qubits can be biased in to "double well mode."

Implementations of the quantum subject matter and quantum operations described in this specification can be implemented in suitable quantum circuitry or, more generally, quantum computational systems, also referred to as quantum information processing systems, including the structures disclosed in this specification and their structural equivalents, or in combinations of one or more of them. The terms "quantum computational systems" and "quantum information processing systems" may include, but are not limited to, quantum computers, quantum cryptography systems, topological quantum computers, or quantum simulators.

The terms quantum information and quantum data refer to information or data that is carried by, held or stored in quantum systems, where the smallest non-trivial system is a qubit, e.g., a system that defines the unit of quantum information. It is understood that the term "qubit" encompasses all quantum systems that may be suitably approximated as a two-level system in the corresponding context. Such quantum systems may include multi-level systems, e.g., with two or more levels. By way of example, such systems can include atoms, electrons, photons, ions or superconducting qubits. In some implementations the computational basis states are identified with the ground and first excited states, however it is understood that other setups where the computational states are identified with higher level excited states are possible. It is understood that quantum memories are devices that can store quantum data for a long time with high fidelity and efficiency, e.g., light-matter interfaces where light is used for transmission and matter for storing and preserving the quantum features of quantum data such as superposition or quantum coherence.

Quantum circuit elements (also referred to as quantum computing circuit elements) include circuit elements for performing quantum processing operations. That is, the quantum circuit elements are configured to make use of quantummechanical phenomena, such as superposition and entanglement, to perform operations on data in a non-deterministic manner. Certain quantum circuit elements, such as qubits, can be configured to represent and operate on information in more than one state simultaneously. Examples of superconducting quantum circuit elements include circuit elements such as quantum LC oscillators, qubits (e.g., flux qubits, phase qubits, or charge qubits), and superconducting quantum interference devices (SQUIDs) (e.g., RF-SQUID or DC-SQUID), among others.

In contrast, classical circuit elements generally process data in a deterministic manner. Classical circuit elements can be configured to collectively carry out instructions of a computer program by performing basic arithmetical, logical, and/or input/output operations on data, in which the data is represented in analog or digital form. In some implementations, classical circuit elements can be used to transmit data to and/or receive data from the quantum circuit elements through electrical or electromagnetic connections. Examples of classical circuit elements include circuit elements based on CMOS circuitry, rapid single flux quantum (RSFQ) devices, reciprocal quantum logic (RQL) devices and ERSFQ devices, which are an energyefficient version of RSFQ that does not use bias resistors.

Fabrication of the quantum circuit elements and classical circuit elements described herein can entail the deposition of one or more materials, such as superconductors, dielectrics and/or metals. Depending on the selected material, these materials can be deposited using deposition processes such as chemical vapor deposition, physical vapor deposition (e.g., evaporation or sputtering), or epitaxial techniques, among other deposition processes. Processes for fabricating circuit elements described herein can entail the removal of one or more materials from a device during fabrication. Depending on the material to be removed, the removal process can include, e.g., wet etching techniques, dry etching techniques, or lift-off processes. The materials forming the circuit elements described herein can be patterned using known lithographic techniques (e.g., photolithography or e-beam lithography).

During operation of a quantum computational system that uses superconducting quantum circuit elements and/or superconducting classical circuit elements, such as the circuit elements described herein, the superconducting circuit elements are cooled down within a cryostat to temperatures that allow a superconductor material to exhibit superconducting properties. A superconductor (alternatively superconducting) material can be understood as material that exhibits superconducting properties at or below a superconducting critical temperature. Examples of superconducting material include aluminum (superconductive critical temperature of about 1.2 kelvin), indium (superconducting critical temperature of about 3.4 kelvin), NbTi (superconducting critical temperature of about 10 kelvin) and niobium (superconducting critical temperature of about 9.3 kelvin). Accordingly, superconducting structures, such as superconducting traces and superconducting ground planes, are formed from material that exhibits superconducting properties at or below a superconducting critical temperature.

While this specification contains many specific implementation details, these should not be construed as limitations on the scope of what may be claimed, but rather as descriptions of features that may be specific to particular implementations. Certain features that are described in this specification in the context of separate implementations can also be implemented in combination in a single implementation. Conversely, various features that are described in the context of a single implementation can also be implemented in multiple implementations separately or in any suitable sub-combination.

Similarly, while operations are depicted in the drawings in a particular order, this should not be understood as requiring that such operations be performed in the particular order shown or in sequential order, or that all illustrated operations be performed, to achieve desirable results. For example, the actions recited in the claims can be performed in a different order and still achieve desirable results. In certain circumstances, multitasking and parallel processing may be advantageous. Moreover, the separation of various components in the implementations described above should not be understood as requiring such separation in all implementations.

A number of embodiments of the invention have been described. Nevertheless, it will be understood that various modifications may be made. Accordingly, other embodiments are within the scope of the following claims.

## Claims

1. A method comprising:
providing a data qubit and a flux qubit (410) for measuring a state of the data qubit (201);
exciting the data qubit into an excited state;
biasing the flux qubit into a single well potential energy configuration;
tuning the flux qubit so that a photon from the excited state of the data qubit is transferred to the flux qubit;
biasing the flux qubit containing the transferred photon into a double well potential energy configuration, wherein biasing the flux qubit containing the transferred photon into the double well potential energy configuration comprises tilting a potential energy curve of the flux qubit; and
adiabatically raising a potential barrier between a first well and a second well of the double well potential energy configuration so that energy states of the flux qubit containing the transferred photon are mapped to the first well and the second well of the double well potential energy configuration, wherein either the first well or the second well comprises the transferred photon, and wherein the raised potential well prevents leakage of the transferred photon into an adjacent well of the double well potential energy configuration;
measuring the state of the data qubit by reading out the energy states of the flux qubit.

2. The method of claim 1, wherein tuning the flux qubit (410) so that the photon from the excited state of the data qubit (201) is transferred to the flux qubit comprises tuning the flux qubit to be in resonance with the data qubit in the excited state.

3. The method of claim 1 or claim 2, wherein reading out the energy states of the flux qubit (410) comprises applying microwave reflectometry to the flux qubit.

4. The method of claim 1 or claim 2, wherein reading out the energy states of the flux qubit (410) comprises reading out a flux difference between a first energy state and a second energy state of the flux qubit.

5. The method of claim 4, wherein reading out the flux difference is performed using a single flux quantum, SFQ, to measure the flux difference.

6. The method of any one of claims 1 to 5, wherein the data qubit (201) is a transmon qubit.

7. The method of any one of claims 1 to 6, wherein the data qubit (201) is on a first substrate and the flux qubit (410) is on a second substrate that is bonded to the first substrate.

8. The method of claim 1, wherein biasing the flux qubit into a single well potential energy configuration and tuning the flux qubit so that a photon from the excited state of the data qubit is transferred to the flux qubit further comprises:
determining bias condition for a single well configuration and a double well configuration of a flux qubit (410) such that the flux qubit is at an interaction frequency at the single well configuration, wherein at the interaction frequency the flux qubit is resonant with a data qubit (201);
determining a first bias condition for the data qubit for the interaction frequency;
determining a second bias condition for the data qubit for a frequency away from the interaction frequency; and
applying a microwave pulse to the data qubit to prepare a state and to tune into the interaction frequency.

## Patentansprüche

1. Verfahren, umfassend:
Bereitstellen eines Daten-Qubits und eines Fluss-Qubits (410) zum Messen eines Zustands des Daten-Qubits (201);
Anregen des Daten-Qubits in einen angeregten Zustand;
Vorspannen des Flussqubits in eine Einzeltopf-Potentialenergiekonfiguration;
Abstimmen des Flussqubits, sodass ein Photon aus dem angeregten Zustand des Daten-Qubits auf das Flussqubit übertragen wird;
Vorspannen des Flussqubits, das das übertragene Photon enthält, in eine Doppeltopf-Potentialenergiekonfiguration, wobei das Vorspannen des Flussqubits, das das übertragene Photon enthält, in die Doppeltopf-Potentialenergiekonfiguration das Kippen einer Potential-Energiekurve des Flussqubits umfasst; und
adiabatisches Anheben einer Potentialbarriere zwischen einem ersten Topf und einem zweiten Topf der Doppeltopf-Potentialenergiekonfiguration, sodass Energiezustände des Flussqubits, die das übertragene Photon enthalten, auf den ersten Topf und den zweiten Topf der Doppeltopf-Potentialenergiekonfiguration abgebildet werden, wobei entweder der erste Topf oder der zweite Topf das übertragene Photon umfasst und wobei der angehobene Potentialtopf ein Entweichen des übertragenen Photons in einen benachbarten Topf der Doppeltopf-Potentialenergiekonfiguration verhindert;
Messen des Zustands des Daten-Qubits durch Auslesen der Energiezustände des Flussqubits.

2. Verfahren nach Anspruch 1, wobei das Abstimmen des Flussqubits (410), sodass das Photon aus dem angeregten Zustand des Daten-Qubits (201) auf das Flussqubit übertragen wird, Abstimmen des Flussqubits umfasst, um in Resonanz mit dem DatenQubit in dem angeregten Zustand zu sein.

3. Verfahren nach Anspruch 1 oder Anspruch 2, wobei das Auslesen der Energiezustände des Flussqubits (410) Anwenden von Mikrowellenreflektometrie auf das Flussqubit umfasst.

4. Verfahren nach Anspruch 1 oder Anspruch 2, wobei das Auslesen der Energiezustände des Flussqubits (410) Auslesen einer Flussdifferenz zwischen einem ersten Energiezustand und einem zweiten Energiezustand des Flussqubits umfasst.

5. Verfahren nach Anspruch 4, wobei das Auslesen der Flussdifferenz unter Verwendung eines Einzel-Flussquants (single flux quantum, SFQ) zum Messen der Flussdifferenz durchgeführt wird.

6. Verfahren nach einem der Ansprüche 1 bis 5, wobei das DatenQubit (201) ein Transmon-Qubit ist.

7. Verfahren nach einem der Ansprüche 1 bis 6, wobei sich das Daten-Qubit (201) auf einem ersten Substrat und das Flussqubit (410) auf einem zweiten Substrat befindet, das mit dem ersten Substrat verbunden ist.

8. Verfahren nach Anspruch 1, wobei das Vorspannen des Flussqubits in eine Einzeltopf-Potentialenergiekonfiguration und das Abstimmen des Flussqubits, sodass ein Photon aus dem angeregten Zustand des Daten-Qubits auf das Flussqubit übertragen wird, ferner Folgendes umfasst:
Bestimmen einer Vorspannungsbedingung für eine Einzeltopf-Konfiguration und eine Doppeltopf-Konfiguration eines Flussqubits (410), sodass sich das Flussqubit bei der Einzeltopf-Konfiguration auf einer Wechselwirkungsfrequenz befindet, wobei das Flussqubit bei der Wechselwirkungsfrequenz mit einem Datenqubit (201) in Resonanz steht;
Bestimmen einer ersten Vorspannungsbedingung für das Daten-Qubit für die Wechselwirkungsfrequenz;
Bestimmen einer zweiten Vorspannungsbedingung für das DatenQubit für eine von der Wechselwirkungsfrequenz entfernte Frequenz; und
Anwenden eines Mikrowellenpulses auf das Daten-Qubit, um einen Zustand vorzubereiten und sich auf die Wechselwirkungsfrequenz einzustellen.

## Revendications

1. Procédé comprenant :
la fourniture d'un qubit de données et d'un qubit de flux (410) pour la mesure d'un état du qubit de données (201) ;
l'excitation du qubit de données dans un état excité ;
la polarisation du qubit de flux dans une configuration d'énergie potentielle à puits unique ;
le réglage du qubit de flux de sorte qu'un photon provenant de l'état excité du qubit de données soit transféré au qubit de flux ;
la polarisation du qubit de flux contenant le photon transféré dans une configuration d'énergie potentielle à double puits, dans lequel la polarisation du qubit de flux contenant le photon transféré dans la configuration d'énergie potentielle à double puits comprend l'inclinaison d'une courbe d'énergie potentielle du qubit de flux ; et
l'élévation adiabatique d'une barrière de potentiel entre un premier puits et un second puits de la configuration d'énergie potentielle à double puits de sorte que des états d'énergie du qubit de flux contenant le photon transféré soient associés au premier puits et au second puits de la configuration d'énergie potentielle à double puits, dans lequel soit le premier puits, soit le second puits comprend le photon transféré, et dans lequel le puits de potentiel élevé empêche la fuite du photon transféré dans un puits adjacent de la configuration d'énergie potentielle à double puits ;
la mesure de l'état du qubit de données en lisant les états énergétiques du qubit de flux.

2. Procédé selon la revendication 1, dans lequel le réglage du qubit de flux (410) de sorte que le photon de l'état excité du qubit de données (201) soit transféré au qubit de flux comprend le réglage du qubit de flux pour qu'il soit en résonance avec le qubit de données dans l'état excité.

3. Procédé selon la revendication 1 ou la revendication 2, dans lequel la lecture des états énergétiques du qubit de flux (410) comprend l'application de la réflectométrie micro-ondes au qubit de flux.

4. Procédé selon la revendication 1 ou la revendication 2, dans lequel la lecture des états énergétiques du qubit de flux (410) comprend la lecture d'une différence de flux entre un premier état énergétique et un second état énergétique du qubit de flux.

5. Procédé selon la revendication 4, dans lequel la lecture de la différence de flux est réalisée à l'aide d'un seul quantum de flux, SFQ, pour mesurer la différence de flux.

6. Procédé selon l'une quelconque des revendications 1 à 5, dans lequel le qubit de données (201) est un qubit transmon.

7. Procédé selon l'une quelconque des revendications 1 à 6, dans lequel le qubit de données (201) est sur un premier substrat et le qubit de flux (410) est sur un second substrat qui est fixé au premier substrat.

8. Procédé selon la revendication 1, dans lequel la polarisation du qubit de flux dans une configuration d'énergie potentielle à puits unique et le réglage du qubit de flux de sorte qu'un photon de l'état excité du qubit de données soit transféré au qubit de flux, comprend également :
la détermination d'une condition de polarisation pour une configuration à puits unique et une configuration à double puits d'un qubit de flux (410) de telle sorte que le qubit de flux soit à une fréquence d'interaction dans la configuration à puits unique, dans lequel à la fréquence d'interaction le qubit de flux est en résonance avec un qubit de données (201) ;
la détermination d'une première condition de polarisation pour le qubit de données, correspondant à la fréquence d'interaction ;
la détermination d'une seconde condition de polarisation pour le qubit de données, correspondant à une fréquence différente de la fréquence d'interaction ; et
l'application d'une impulsion micro-ondes au qubit de données pour préparer un état et le régler sur la fréquence d'interaction.
